# EUROPEAN PATENT APPLICATION

(11) **EP 2 081 291 A1**
(43) Date of publication of application: **22.07.2009**
(21) Application number: 08100629.8
(22) Date of filing: 18.01.2008
(51) Int. Cl.: H03B 5/04, H03L 1/02

(54) **Biasing circuit and method for voltage controlled oscillators**

(71) Applicant: Seiko Epson Corporation, Tokyo 163-0811 (JP)
(72) Inventor: Redondo Navarro, Xavier c/o Centro Nacional de Microelectrónic, 08193 Barcelona (ES); Tanaka, Kazuaki c/o EPSON EUROPE ELECTRONICS GmbH, Sant Cugat del Vallés (Barcelona) 08190 (ES); Gil Gali, Ignacio c/o EPSON EUROPE ELECTRONICS GmbH, Sant Cugat del Vallés (Barcelona) 08190 (ES); Cairo Molins, Josep Ignasi c/o EPSON EUROPE ELECTRONICS GmbH, Sant Cugat del Vallés (Barcelona) 08190 (ES); Terés Terés, Lluis c/o Centro Nacional de Microelectrónic, 08193 Barcelona (ES); Serra Graells, Francesc c/o Centro Nacional de Microelectrónic, 08193 Barcelona (ES); Pallarès Cuxart, Jofre c/o Centro Nacional de Microelectrónic, 08193 Barcelona (ES)
(74) Representative: Carpintero Lopez, Francisco

(57) **Abstract**

A self-biased voltage controlled oscillator comprising: a VCO core (25, 35, 45) having output voltages (27, 29; 37, 39; 47, 49); a first current source (23, 32, 42) having a first fixed current value, configured for injecting a current to said VCO core (25, 35, 45); a second current source (21, 33, 41) having a second fixed current value, configured for sinking a current from said VCO core (25, 35, 45). It further comprises a third current source (22, 31, 43) having a variable current, said third current source (22, 31, 43) being connected to said VCO core (25, 35, 45) and to an output of a feedback circuitry configured for adjusting an internal common mode voltage (28, 38, 43) applied to said VCO core (25, 35, 45), such that the difference between said common mode voltage (28, 38, 48) and an external reference voltage (24, 34, 44) applied to said feedback circuitry is minimized.

## Description

### FIELD OF THE INVENTION

The present invention relates to voltage controlled oscillators (VCOs) and more particularly, to biasing methods and circuits for VCOs.

### STATE OF THE ART

Voltage Controlled Oscillators (VCO) are one of the key blocks of nowadays communications circuits. They are commonly used in phase-locked loops (PLLs). They are responsible for generating the radio frequency (RF) carrier signal. This RF carrier signal usually needs to be generated with very high precision.

In monolithically integrated communication circuits, electrical noise coming from other blocks can degrade the performance of the VCO.

On the other hand, varactors (capacitors whose capacitance value varies according to an input voltage) are commonly used in monolithically integrated VCOs. They need to be polarized at a certain voltage to operate properly. The output voltage of the VCO also depends strongly of the polarization point of these varactors. Another current problem of VCOs is the biasing of the varactors.

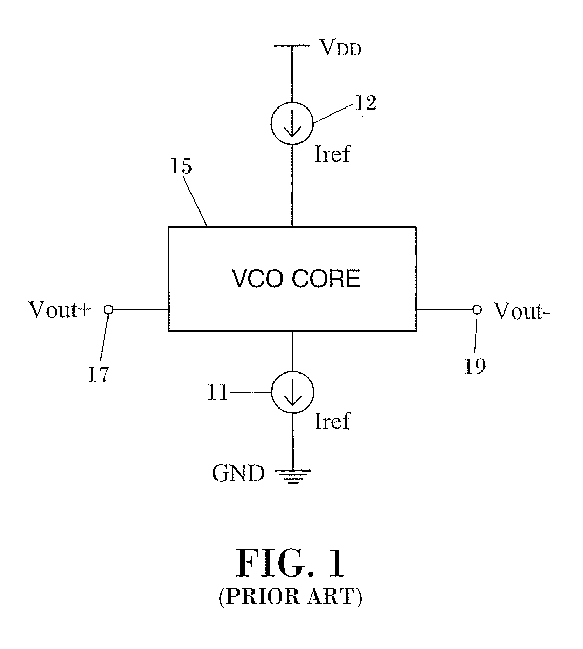

A conventional VCO circuit configuration with double current source is illustrated in figure 1. As shown in figure 1, the isolation from V_{DD} and GND perturbations can be achieved by biasing the VCO core 15 with two current sources 11 12, one 12 injecting a current equal to Iref while the other one 11 is sinking a current with the same value. The perturbations on power and ground nodes are mainly absorbed by these current sources 11 12, providing a good isolation of the VCO core 15.

However, introducing these current sources 11 12 makes the output voltage operation point 17 19 very sensitive to the difference between these sources 11 12. Although the current sources 11 12 have the same nominal value Iref, technological differences always exist and the current difference between these sources 11 12 causes an uncertainty of the voltage levels that can be found inside the VCO core 15. Therefore, a control of the Common Mode Voltage (VCM) needs to be introduced.

US patent 6765448 B2 discloses a self-biased voltage controlled oscillator (VCO) that includes a VCO core including a plurality of switching transistors, a resonant tank circuit coupled to the VCO core, a current source coupled to the VCO core and a biasing circuit coupled to both the resonant tank circuit and to the current source. In this case, the isolation is made by introducing two inductors at the top and bottom nodes of the VCO core, having also a good isolation from power lines perturbations. However, the common voltage is controlled by an automatic biasing circuit, and small differences between fabrication and design of the nominal values of the devices can make the designed Common Mode Voltage (VCM) vary a lot. In addition to this, the introduction of two additional inductors results in a high increase of the area used to implement the circuit, due to the relative big dimensions of these devices.

US patent 6788161 B2 discloses an oscillator circuit for use in a local oscillator of an RF communications device that communicates over an RF channel. It tries to enhance isolation from the bias circuitry, but it does not control the operating voltages of the VCO core. What is more, it needs a lot of extra circuitry, resulting in a increase of the power consumption and the area occupied by the overall system.

US patent 7075379 B2 discloses a voltage-controlled oscillator circuit connected to supply a reference voltage for radio frequency operation. Although it provides good isolation from supply perturbations, since the common voltage node is not monitored, it can not control the exact operating point. Although it can be fixed by a proper design of the bias voltage and the dimensions of the MOS transistors, again small differences between design and fabrication alter the desired operating point.

### SUMMARY OF THE INVENTION

It is therefore an object of the present invention to provide a circuit and a method for accurately biasing voltage controlled oscillators while allowing isolating the sensitive parts of the VCO against the noise coming from power supplies and ground and while controlling also the polarization of the circuit.

It is a primary aim of the present invention to provide a self-biased voltage controlled oscillator comprising: a VCO core comprising a plurality of inductive elements, capacitive elements and transistors for generating an oscillation, said VCO core having output voltages; a first current source having a first fixed current value, configured for injecting a current to said VCO core; a second current source having a second fixed current value, configured for sinking a current from said VCO core. It further comprises a third current source having a variable current, said third current source being connected to said VCO core and to an output of a feedback circuitry configured for adjusting an internal common mode voltage applied to said VCO core, such that the difference between said common mode voltage and an external reference voltage applied to said feedback circuitry is minimized.

The feedback circuitry preferably comprises an amplifying stage.

In a particular embodiment, the third current source is preferably configured for sinking a current from said VCO core.

Alternatively, the third current source is configured for injecting a current to said VCO core.

In a particular embodiment, the VCO core comprises a double-switch pair configuration, a differential inductor and at least one varactor. In this implementation, the self-biased voltage controlled oscillator can comprise an external voltage configured for polarising the at least one varactor.

The VCO core can comprise two varactors. In this implementation, the self-biased voltage controlled oscillator further comprises an external voltage configured for polarising those two varactors.

The feedback circuitry preferably comprises a plurality of transistors and a current source.

The third current source having a variable current is preferably implemented by means of a p-type transistor.

It is another aim of the present invention to provide a method of self-biasing a voltage controlled oscillator, comprising the steps of: injecting a first fixed current value from a first source to a VCO core, said VCO core comprising a plurality of inductive elements, capacitive elements and transistors for generating an oscillation; sinking a second fixed current value to a second source from said VCO core. The method further comprises the steps of: connecting a third current source to said VCO core; connecting said third current source to an output of a feedback circuitry; minimizing the differences between an internal common mode voltage applied to said VCO core and an external reference voltage applied to said feedback circuitry by adjusting the current value of said third current source.

Preferably, the method further comprising the step of polarising at least one varactor comprised in said VCO core.

The advantages of the proposed invention will become apparent in the description that follows.

### BRIEF DESCRIPTION OF THE DRAWINGS

To complete the description and in order to provide for a better understanding of the invention, a set of drawings is provided. Said drawings form an integral part of the description and illustrate a preferred embodiment of the invention, which should not be interpreted as restricting the scope of the invention, but just as an example of how the invention can be embodied. The drawings comprise the following figures:
Figure 1 is a prior art VCO circuit configuration with double current source.
Figure 2 is a VCO circuit configuration with upper current source feedback according to the present invention.
Figure 3 is a VCO circuit configuration with lower current source feedback according to the present invention.
Figure 4 is a VCO circuit configuration with upper current source feedback according to a preferred embodiment of the present invention.

### DESCRIPTION OF PREFERRED EMBODIMENTS OF THE INVENTION

In this context of the present invention, the term "VCO core" refers to a voltage-controlled resonant circuit which comprises a plurality of inductive and capacitive elements as well as transistors in order to generate an oscillation.

The implementation of the present invention can be carried out as follows:

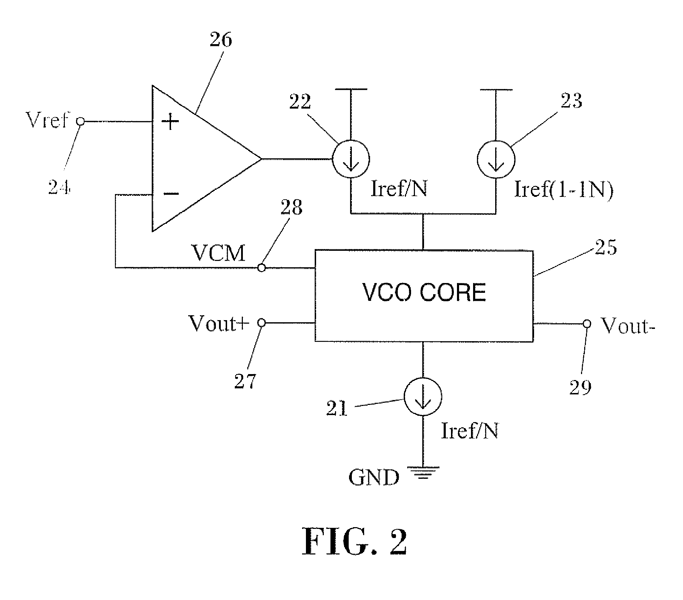

Figure 2 shows a self-biased voltage controlled oscillator circuit according to an embodiment of the invention. The circuit of figure 2 comprises a VCO core 25. The VCO core 25 is biased by means of three current sources 21 22 23, which provide the amount of current needed for a proper operation of the resonant circuit. Two of these sources 22 23 inject a current to the VCO core 25, while a third one 21 sinks a current therefrom. Sources 22 23 inject its respective current to a same point of the VCO core 25.

Current source 22 injects a current equal to Iref/N, current source 23 injects a current equal to Iref(1-1/N) and current source 21 sinks a current equal to Iref/N. Parameter N varies within a minimum value of around 0.03 and a maximum value of around 0.7, more preferably between around 0.05 and around 0.5, and still more preferably between around 0.05 and around 0.2.

A portion of current source 22 is controlled in order to achieve the desired Common Mode Voltage (VCM) 28, which is the average voltage between the two outputs Vout+ 27 and Vout- 29 of the VCO core 25: ((Vout+) + (Vout-))/2 = VCM.

As already mentioned, the total amount of injected current Iref is divided into two current sources 22 23. An amplifying stage 26 is introduced in a feedback loop in order to control the current source 22. The purpose of amplifying stage 26 is to try to balance or make equal the Common Mode Voltage (VCM) 28 and a reference voltage Vref 24. In order to achieve this purpose, amplifying stage 26 closes a negative feedback loop.

Amplifying stage 26 is a conventional one. Non-limiting examples of such amplifying stages that can be used in the circuit of figure 2 are typical operational amplifiers (OPAMPS) and any circuit which can generate a voltage gain operation. Typical gain values of these amplifying stages vary from a minimum value of around 0.0005 to a maximum value which depends on the technological parameters.

The input signal of this amplifying stage 26 is the difference between the Common Mode Voltage (VCM) 28 and the desired Vref voltage 24. If the amplifying stage 26 has enough gain, the difference between Vref 24 and VCM 28 is minimized thanks to the negative feedback loop, as is apparent to those skilled in the art.

Therefore, a simple way to adjust the desired VCM voltage 28 is provided.

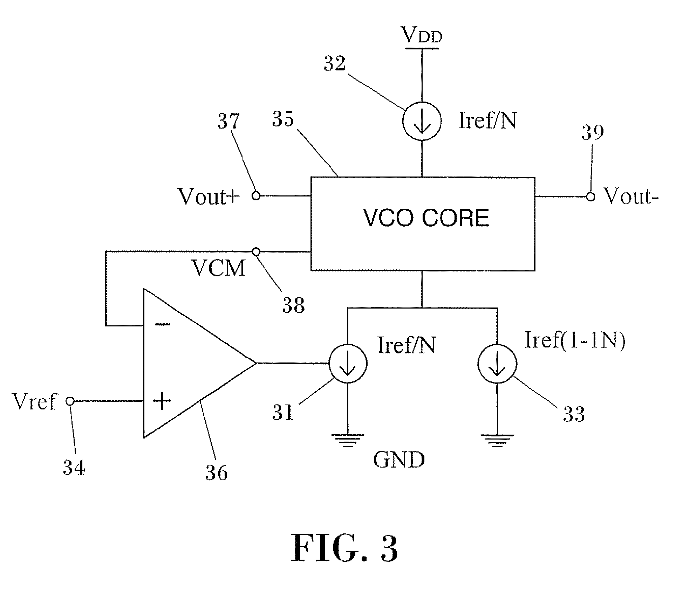

Figure 3 shows a self-biased voltage controlled oscillator circuit according to an alternative embodiment of the invention. This circuit is similar to that of figure 2 but, in figure 3, the feedback circuitry is applied to a lower current source 31. The circuit of figure 3 comprises a VCO core 35 which is biased by means of three current sources 31 32 33. One of these sources 32 injects a current to the VCO core 35, while a second and a third ones 31 33 sink a current therefrom. Sources 31 33 sink its respective current from a same point of the VCO core 35.

Current source 32 injects a current equal to Iref/N, current source 31 sinks a current equal to Iref/N and current source 33 sinks a current equal to Iref(1-1/N). Parameter N varies within a minimum value of around 0.03 and a maximum value of around 0.7, more preferably between around 0.05 and around 0.5, and still more preferably between around 0.05 and around 0.2.

A portion of current source 31 is controlled in order to achieve the desired Common Mode Voltage (VCM) 38, which again is the average voltage between the two outputs Vout+ 37 and Vout- 39 of the VCO core 35: ((Vout+) + (Vout-))/2 = VCM.

As already mentioned, the total amount of sinked current Iref is divided into two current sources 31 33. An amplifying stage 36 is introduced in a feedback loop in order to control the current source 31. Amplifying stage 36 is a conventional one. Non-limiting examples of such amplifying stages that can be used in the circuit of figure 3 are typical operational amplifiers (OPAMPS) and any circuit which can generate a voltage gain operation. Typical gain values of these amplifying stages vary from a minimum value of around 0.0005 to a maximum value which depends on the technological parameters.

The input signal of this amplifying stage 36 is the difference between the Common Mode Voltage (VCM) 38 and the desired Vref voltage 34. If the amplifying stage 36 has enough gain, the difference between Vref 34 and VCM 38 is minimized thanks to the negative feedback loop, as is apparent to those skilled in the art. Therefore, a simple way to adjust the desired VCM voltage 38 is provided.

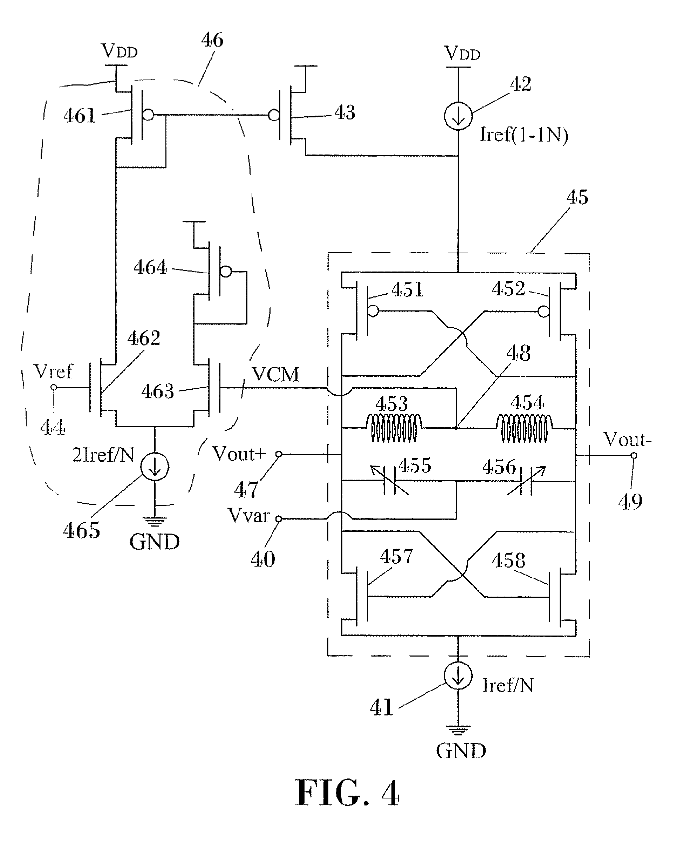

Figure 4 shows a self-biased voltage controlled oscillator VCO circuit configuration with upper current source feedback and automatic biasing circuitry according to a preferred embodiment of the present invention. The VCO core 45 is depicted in detail. It has a typical double-switch pair VCO (DS-VCO) core which has been employed with a center tap differential inductor in order to sense the VCM. Four transistors 451 452 457 458 form a so-called "negative resistance generator", as can be apparent to those skilled in the art. The voltage outputs of the VCO core 45 swing around the VCM voltage 48. A pair of varactors 455 456 has been employed as capacitor in the LC tank. In this example, Vref has been fixed to the half of the supply voltage V_{DD}. As the center operation voltage of the varactors has been fixed to Vref, an RC network is no more necessary to polarize it. A voltage Vvar 40 is needed to polarize properly the varactors 455 456, which form the center tap differential inductor to a voltage being the result of subtracting VCM 48 minus Vvar 40. The value of voltage Vvar 40 varies within a minimum value of around 10% of the feeding voltage V_{DD} and a maximum value of around 90% of the feeding voltage V_{DD}, more preferably between around 40% of the feeding voltage V_{DD} and around 60% of the feeding voltage V_{DD}. These values depend on the technological parameters. This voltage Vvar 40 is used to adjust the capacitance value of the varicaps 455 456 which form part of the VCO core 45.

In this implementation, the amplifying stage 46 is formed by transistors 461 462 463 464 together with the current source 465. Current source 43 is implemented by means of a p-type transistor 43. The automatic control of voltage VCM 48 takes place as follows: amplifier 46 acts on transistor 43, which acts as current source. Due to the inherent properties of p-transistors, the lower the voltage provided by amplifying stage 46 is, the higher the current injected by transistor 43 is.

From this implementation we can see two other benefits of controlling the Common Mode Voltage (VCM) 38:
If a varactor is present in the VCO core 45, it can be correctly polarized at the optimum voltage, without a need of extra polarization circuitry that can worse its quality factor.

The control of the Common Mode Voltage (VCM) 38 enables an optimum polarization of the VCO output 47 49 without a need of a typical RC network. Thus, the equivalent quality factor of the LC of the VCO core 45 is maintained constant.

In all these embodiments illustrated in figures 2, 3 and 4, the control circuit senses the common node of the VCO core using an error amplifying stage and keeping this node to a desired voltage by controlling the current source/sink or both. As a result, the operation point of the active devices which form part of the VCO core can be optimized, especially for the varactors.

In this text, the term "comprises" and its derivations (such as "comprising", etc.) should not be understood in an excluding sense, that is, these terms should not be interpreted as excluding the possibility that what is described and defined may include further elements, steps, etc.

In the context of the present invention, the terms "approximately", "about" and "around" and terms of its family (such as "approximate", etc.) should be understood as indicating values very near to those which accompany the aforementioned term. That is to say, a deviation within reasonable limits from an exact value should be accepted, because the expert in the technique will understand that such a deviation from the values indicated is inevitable due to measurement inaccuracies, etc.

The invention is obviously not limited to the specific embodiments described herein, but also encompasses any variations that may be considered by any person skilled in the art (for example, as regards the choice of components, configuration, etc.), within the general scope of the invention as defined in the appended claims.

## Claims

1. A self-biased voltage controlled oscillator comprising:
- a VCO core (25, 35, 45) comprising a plurality of inductive elements, capacitive elements and transistors for generating an oscillation, said VCO core (25, 35, 45) having output voltages (Vout+ Vout-; 27, 29; 37, 39; 47, 49);
- a first current source (23, 32, 42) having a first fixed current value, configured for injecting a current to said VCO core (25, 35, 45);
- a second current source (21, 33, 41) having a second fixed current value, configured for sinking a current from said VCO core (25, 35, 45);
**characterised in that** it further comprises a third current source (22, 31, 43) having a variable current, said third current source (22, 31, 43) being connected to said VCO core (25, 35, 45) and to an output of a feedback circuitry configured for adjusting an internal common mode voltage (28, 38, 48) applied to said VCO core (25, 35, 45), such that the difference between said common mode voltage (28, 38, 48) and an external reference voltage (24, 34, 44) applied to said feedback circuitry is minimized.

2. A self-biased voltage controlled oscillator according to claim 1, wherein said feedback circuitry comprises an amplifying stage (26, 36, 46).

3. A self-biased voltage controlled oscillator according to either claim 1 or 2, wherein said third current source (31) is configured for sinking a current from said VCO core (35).

4. A self-biased voltage controlled oscillator according to either claim 1 or 2, wherein said third current source (22, 43) is configured for injecting a current to said VCO core (25, 45).

5. A self-biased voltage controlled oscillator according to claim 4, wherein said VCO core (45) comprises a double-switch pair configuration (451, 452, 457, 458), a differential inductor (453, 454) and at least one varactor (455, 456).

6. A self-biased voltage controlled oscillator according to claim 5, further comprising an external voltage (40) configured for polarising said at least one varactor (455, 456).

7. A self-biased voltage controlled oscillator according to claim 5, wherein said VCO core (45) comprises two varactors (455, 456).

8. A self-biased voltage controlled oscillator according to claim 7, further comprising an external voltage (40) configured for polarising said two varactors (455, 456).

9. A self-biased voltage controlled oscillator according to any claim from 5 to 8, wherein said feedback circuitry comprises a plurality of transistors (461 462 463 464) and a current source (465).

10. A self-biased voltage controlled oscillator according to any preceding claim from 5 to 9, wherein said third current source (43) having a variable current is implemented by means of a p-type transistor.

11. Method of self-biasing a voltage controlled oscillator, comprising the steps of:
- injecting a first fixed current value from a first source (23, 32, 42) to a VCO core (25, 35, 45), said VCO core (25, 35, 45) comprising a plurality of inductive elements, capacitive elements and transistors for generating an oscillation;
- sinking a second fixed current value to a second source (21, 33, 41) from said VCO core (25, 35, 45);
**characterised in that** it further comprises the steps of:
- connecting a third current source (22, 31, 43) to said VCO core (25, 35, 45);
- connecting said third current source (22, 31, 43) to an output of a feedback circuitry;
- minimizing the differences between an internal common mode voltage (28, 38, 48) applied to said VCO core (25, 35, 45) and an external reference voltage (24, 34, 44) applied to said feedback circuitry by adjusting the current value of said third current source (22, 31, 43).

12. Method according to claim 11, further comprising the step of polarising at least one varactor (455, 456) comprised in said VCO core (25, 35, 45).
